# EUROPÄISCHE PATENTSCHRIFT

(11) **EP 2 984 667 B1**
(45) Veröffentlichungstag und Bekanntmachung des Hinweises auf die Patenterteilung: **16.09.2020**
(21) Anmeldenummer: 14716359.6
(22) Anmeldetag: 10.04.2014
(51) Int. Cl.: H01H 3/12, H01H 3/02, H01H 3/00

(54) **VORRICHTUNG ZUR BEDIENUNG MEHRERER FUNKTIONEN IN EINEM KRAFTFAHRZEUG**
DEVICE FOR OPERATING MULTIPLE FUNCTIONS IN A MOTOR VEHICLE
DISPOSITIF PERMETTANT DE COMMANDER PLUSIEURS FONCTIONS DANS UN VÉHICULE À MOTEUR

(30) Priorität: 13.04.2013 DE 102013006414
(43) Veröffentlichungstag der Anmeldung: 17.02.2016
(73) Patentinhaber: KOSTAL Automobil Elektrik GmbH & Co. KG, 58513 Lüdenscheid (DE)
(72) Erfinder: BLECKMANN, Michael, 58239 Schwerte-Ergste (DE); MACHATZKE, Corinna, 58579 Schalksmühle (DE)
(74) Vertreter: Kerkmann, Detlef
(86) Internationale Anmeldenummer: PCT/EP2014/057323
(87) Internationale Veröffentlichungsnummer: WO 2014/167076

(56) Entgegenhaltungen:
- EP-A1- 2 372 915
- EP-A1- 2 509 087
- WO-A2-2007/053966
- DE-A1-102008 058 568
- DE-A1-102009 032 634
- US-A- 5 387 261

## Beschreibung

Die Erfindung betrifft eine Vorrichtung zur Bedienung mehrerer Funktionen in einem Kraftfahrzeug, mit einem Bedienelement, welches um eine Drehachse verschwenkbar gelagert ist und dadurch zwischen wenigstens zwei Positionen beweglich ist, wobei zumindest einer der Positionen eine Schaltfunktion zugeordnet ist, wobei durch manuelle Betätigungen des Bedienelements unterschiedliche Funktionen ausgelöst werden können, wobei das Bedienelement an einer Lagerstelle bezüglich der Richtung der Hochachse zentriert gelagert ist, und wobei Endabschnitte der Drehachse des Bedienelements an zwei seitlichen Lagerstellen in zwei entlang einer Hochachse ausgerichteten Langlochführungen gelagert sind.
Eine derartige Vorrichtung ist aus der europäischen Patentanmeldung EP 2 509 087 A1 bekannt.

Die deutsche Offenlegungsschrift DE 10 2010 024 776 A1 zeigt eine Vorrichtung, bei der ein Bedienelement um eine Drehachse verschwenkbar gelagert ist. Das Bedienelement kann insbesondere eine Schaltleiste ausbilden, die mehrere kapazitive Sensorflächen aufweist. Durch ein Verschwenken der Schaltleiste können insbesondere Kippschalter betätigt und so Schaltfunktionen ausgelöst werden. Aus dieser Schrift ist des Weiteren bekannt, dass bei einer Betätigung des Bedienelements eine haptische oder akustische Rückmeldung erfolgt. Beschrieben sind hierzu ein Klickgeräusch und ein mechanischer Widerstand bei einer Betätigung des Bedienelements.

Die DE 10 2010 024 776 A1 offenbart damit das Funktionsprinzip eines Bedienelements, welches berührungssensitive und druckbetätigbare kontaktierende Schaltelemente kombiniert. Das Dokument nennt aber nur wenige Details hinsichtlich eines vorteilhaften mechanischen Aufbaus einer solchen Vorrichtung, insbesondere hinsichtlich der genauen Ausführung und Anordnung von Schaltelementen und der Realisierung einer haptischen Rückmeldung.

Es stellte sich die Aufgabe eine entsprechende Vorrichtung zu schaffen, welche sich durch einen einfachen, kostengünstigen und zugleich stabilen und spielarmen mechanischen Aufbau auszeichnet, und bei der das Bedienelement zentriert und schwenkbar gelagert ist, und eine haptische Rückmeldung auf besonders vorteilhafte Weise erzeugt.

Diese Aufgabe wird erfindungsgemäß dadurch gelöst, dass das Bedienelement beim Betätigen eine haptische Rückmeldung gibt, die durch einen elektromagnetischen Aktuator erfolgt, welcher das Bedienelement in der Achsenrichtung der Drehachse temporär verschiebt, dass das Bedienelement an einer mittleren Lagerstelle zentriert gelagert ist, indem die mittlere Lagerstelle an der die Ober- und Unterseite der Bedienleiste durch entlang der Hochachse ausgerichtete Zentrierabschnitte eingefasst ist, welche durch zwei Gehäuseteile gebildet werden, welche beidseitig des Bedienelements angeordnet sind, und dass sich das Bedienelement auf den Gelenkzapfen von mindestens zwei Schwenkgelenken abstützt, und auf diesen schwimmend gelagert ist.

Die Erfindung ermöglicht es, ein Bedienelement, welches im Wesentlichen durch eine großflächige, leichte und daher von sich aus einer wenig biegesteife Kunststoffleiste ausgebildet sein kann, verschwenk- und verschiebbar zu lagern und dabei zugleich stabil, nahezu spielfrei, reibungsarm und toleranzunempfindlich anzuordnen.

Erreicht wird dies durch eine Kombination einer schwimmenden Lagerung des Bedienelements auf den Gelenkzapfen von Schwenkgelenken und einer vertikal zentrierenden Lagerung des Bedienelements an einem Langloch sowie einer schwimmenden Drehlagerung des Bedienelements an zwei vertikalen Langlochführungen.

Darüber hinaus ist ein elektromagnetischer Aktuator vorgesehen, der beim Auslösen einer Bedienfunktion eine haptische Rückmeldung erzeugt, indem er das Bedienelement in der Achsenrichtung seiner Drehachse temporär verschiebt. Als Aktuator kann vorteilhaft ein Hubankermagnet in Kombination mit einer Rückstellfeder verwendet werden.

Ebenfalls vorteilhaft ist es, wenn sich mindestens einer der Gelenkzapfen der Schwenkgelenke auf einem Kraftsensor abstützt. Besonders vorteilhaft kann der Kraftsensor als ein scheibenförmiger Sensor ausgebildet sein, der nach einem kapazitiven Wirkprinzip funktioniert.

Äußerst vorteilhaft ist es, wenn das Bedienelement durch eine Federkraft gegen den Kraftsensor vorgespannt ist. Hierdurch kann der Kraftsensor sowohl auf das Bedienelement einwirkende Druck- als auch Zugkräfte erfassen und damit Betätigungen des Bedienelements in zwei verschiedenen Richtungen unterscheiden.

Das Bedienelement ist vorzugsweise als eine Schaltleiste ausgebildet, die mehrere nebeneinander angeordnete kapazitive Sensorflächen, sowie eine integrierte Elektronik aufweist.

Im Folgenden soll ein Ausführungsbeispiel der Erfindung anhand der Zeichnung dargestellt und näher erläutert werden. Es zeigen:
- Figur 1: eine schematisch dargestellte Vorrichtung in einer Explosionsansicht,
- Figur 2: die zusammengesetzte Vorrichtung,
- Figuren 3 und 4: je eine Schnittansicht der schematisch dargestellten Vorrichtung,
- Figur 5: eine realitätsnahe Darstellung der Vorrichtung als Gesamtansicht,
- Figur 6: die Vorrichtung mit geöffnetem Gehäuse,
- Figur 7: ein Bedienelement in einer Explosionsansicht.

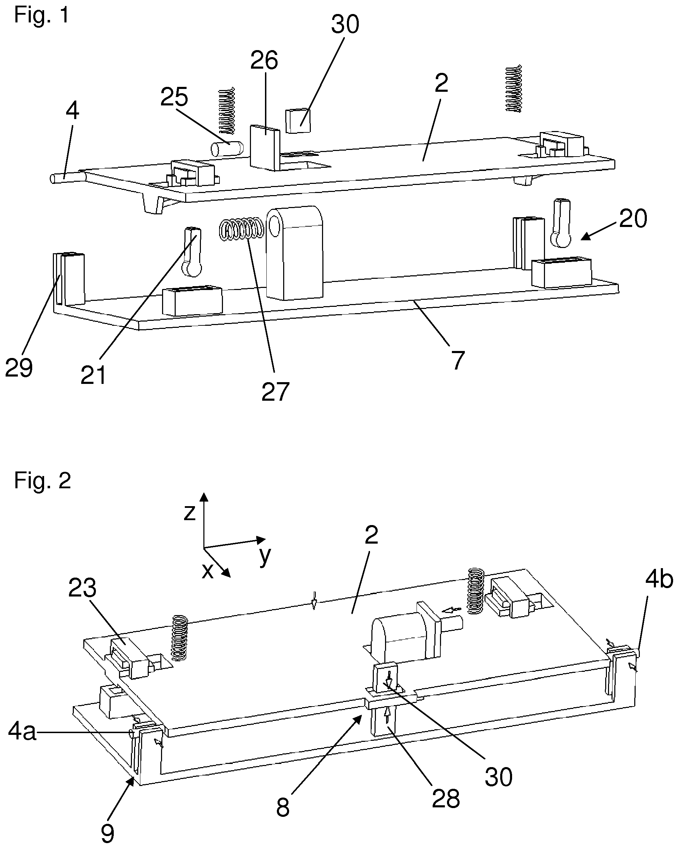

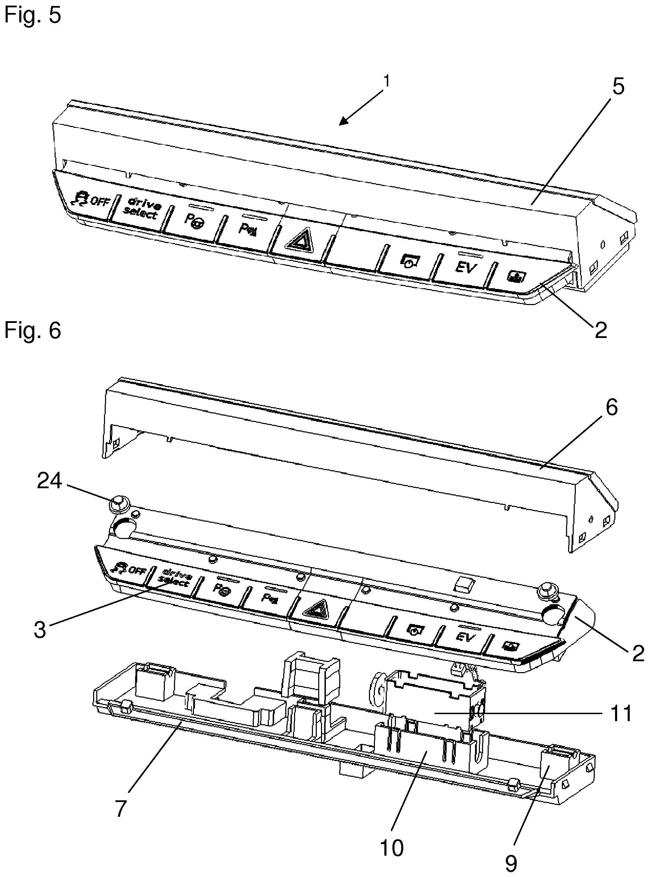

Eine erfindungsgemäße Vorrichtung ist in den Figuren 1 bis 4 grob schematisch und in den Figuren 5 bis 7 realitätsnah dargestellt.

Die Figur 5 zeigt die Vorrichtung 1 im vollständig montierten Zustand; die Figur 6 stellt die Vorrichtung 1 vor dem Zusammenbau des Gehäuses 5 dar. Das Gehäuse 5 besteht aus einem Gehäuseoberteil 6 und einem Gehäuseunterteil 7, zwischen denen ein Bedienelement 2 angeordnet ist. Das Gehäuseunterteil 7 weist eine hier nicht erkennbare mittlere Lagerstelle und zwei angeformte seitliche Lagerstellen 9 für das Bedienelement 2 auf. Des Weiteren ist am Gehäuseunterteil 7 eine Halterung 10 für einen elektromagnetischen Aktuator 11 erkennbar. Der Aktuator 11 ist vorzugsweise als Hubankermagnet ausgebildet und dazu vorgesehen, eine laterale Auslenkung des Bedienelements 2 gegen das Gehäuse 5 zu bewirken.

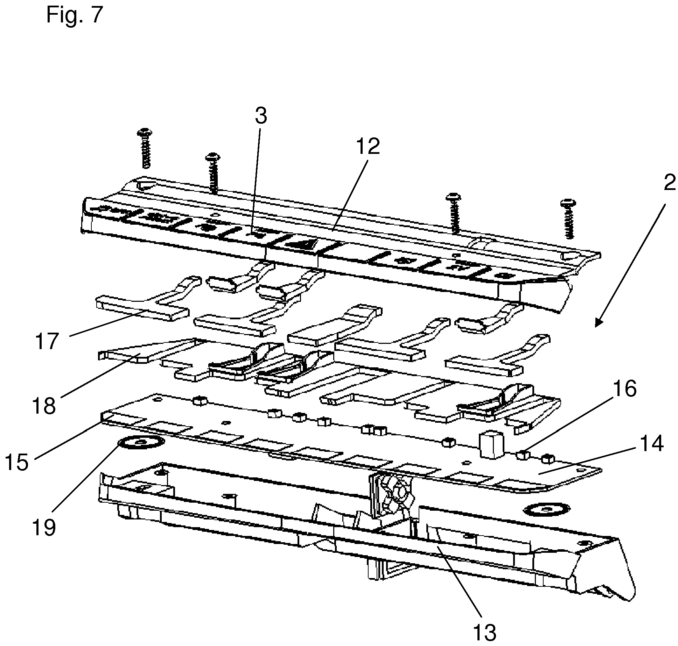

Den inneren Aufbau des Bedienelements 2 zeigt die Figur 7 in einer Explosionsansicht. Das Bedienelement 2 weist eine Schaltleiste 12 und ein Gehäuseteil 13 auf, zwischen denen eine Leiterplatte 14 angeordnet ist. Auf der Leiterplatte 14 ist eine Reihe von kapazitiven Schaltflächen 15 platziert, denen jeweils eine Sensorfläche 3 auf der Schaltleiste 12 zugeordnet ist. Außerdem trägt die Leiterplatte 14 mehrere Lichtquellen 16, die vorzugsweise als LED ausgeführt sind. Das Licht dieser Lichtquellen 16 wird über mehrere Lichtleitkörper 17 und Blendenkörper 18 zur Beleuchtung von Symboldarstellungen zu den Sensorflächen 3 geleitet.

An der Unterseite der Leiterplatte 14 sind scheibenförmige Kraftsensoren 19 angeordnet, die auf das Bedienelement 2 wirkende Betätigungskräfte erfassen können und vorzugsweise nach einem kapazitiven Wirkprinzip funktionieren. Um eine Vielzahl von Bedienfunktionen ansteuerbar zu machen, kann durch Berührung einer der am Bedienelement 2 angeordneten Sensorflächen 3, eine von mehreren auslösbaren Bedienfunktionen vorgewählt werden, welche dann durch eine Druckbetätigung der Bedienleiste 2 bestätigt und ausgelöst wird.

Aufbau und Funktionsweise der erfindungsgemäßen Vorrichtung und insbesondere die Krafterfassung durch den mindestens einen Kraftsensor 19 werden im Folgenden anhand der Figuren 1 bis 4 in stark schematisierten Darstellungen näher erläutert. Das Bedienelement ist hier jeweils vereinfacht als eine Bedienleiste 2 dargestellt, wobei zur Verdeutlichung der Mechanik auf die Darstellung sämtlicher elektrischen und elektronischen Komponenten verzichtet wurde. In den Prinzipskizzen ist zudem das Gehäuseunterteil 7 zu einer Grundplatte 7 vereinfacht worden. Um einen einfachen Vergleich zwischen den realitätsnahen Darstellungen der Figuren 5 bis 7 und den Prinzipdarstellungen der Figuren 1 bis 4 zu ermöglichen, werden in allen Figuren für einander entsprechende Komponenten, trotz teilweise voneinander abweichender Ausführung, die gleichen Bezugszeichen verwendet.

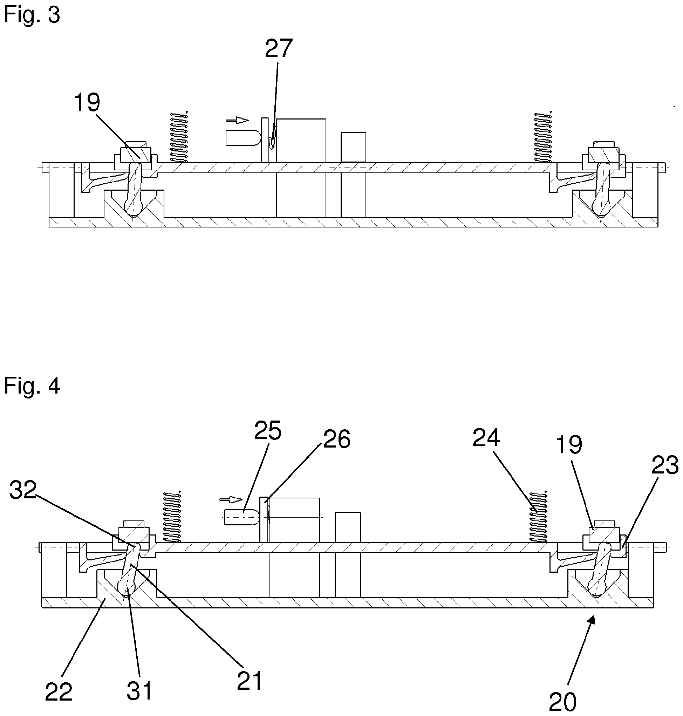

Die Figuren 1 und 2 verdeutlichen den Aufbau und besonders die Lagerung der Bedienleiste 2 an der Grundplatte 7, welche dem Prinzip nach dem Aufbau und der Lagerung des Bedienelements 2 am Gehäuseunterteil 7 in den Figuren 3 bis 7 entspricht. Die Bedienleiste 2 ist um eine Drehachse 4 verschwenkbar an der Grundplatte 7 gelagert. Stiftförmige Endabschnitte 4a, 4b der Drehachse 4 sind in vertikalen Langlochführungen 29 beweglich geführt. Durch die Langlochführungen 29 ist die Lage der Bedienleiste 2 bezüglich der x-Richtung (bezogen auf die in der Figur 2 eingezeichneten Koordinatenachsen x, y, z) festlegt.

Zwischen den vertikalen Langlöchern 29 der seitlichen Lagerstellen 9 befindet sich eine mittlere Lagerstelle 8, an der die Ober- und Unterseite der Bedienleiste 2 durch entlang der Hochachse z ausgerichtete Zentrierabschnitte 28, 30 eng eingefasst ist. Die Zentrierabschnitte 28, 30 sind durch Teilstücke der Gehäuseteile 6, 7 ausgebildet oder mit den Gehäuseteilen 6, 7 verbunden und begrenzen die Beweglichkeit des Bedienelements 2 in vertikaler Richtung.

Eine Verschiebung des Bedienelements 2 entlang dessen Längsrichtung, also in der Erstreckungsrichtung der Drehachse 4 bzw. entlang der y-Richtung des Koordinatenkreuzes kann durch den in der Figur 6 abgebildeten elektromagnetischen Aktuator 11 bewirkt werden, der an dem unteren Gehäuseteil 7 gelagert ist. Stellvertretend für den in den Figuren 1 bis 4 nicht dargestellten Aktuator steht ein zum Aktuator gehörendes ausrückbares Ansteuerelement 25, welches eine Kraft auf einen Anschlagfläche 26 des Bedienelements 2 ausüben kann und dadurch das Bedienelement 2 gegen die Kraft einer Rückstellfeder 27 relativ zur Grundplatte 7 verschiebt.

Um diese Bewegung zu ermöglichen und zugleich ein Verkippen der Bedienleiste 2 um eine zur Drehachse 4 senkrechte Kippachse auszuschließen, ist die Bedienleiste 2 schwimmend auf den Gelenkzapfen 21 zweier Schwenkgelenke 20 gelagert.

Die Schwenkgelenke 20, die besonders deutlich in den Schnittdarstellungen der Figuren 3 und 4 erkennbar sind, bestehen jeweils aus einem Gelenkzapfen 21 mit einem abgerundeten Endabschnitt 31, welcher in einem Gelenklager 22 in zumindest einer Richtung verschwenkbar ist. Die abgerundeten Endabschnitte 31 der Gelenkzapfen 21 können insbesondere auch in Kugelform ausgebildet sein. Die freien Endabschnitte 32 der Gelenkzapfen 21 sind jeweils in einer Aufnahme 23 gelagert, wobei zwischen mindestens einem Gelenkzapfen 21 und einer Anlagefläche in der Aufnahme 23 ein scheibenförmiger Kraftsensor 19 eingesetzt ist.

Der mindestens eine Kraftsensor 19 erfasst Betätigungskräfte, die auf die Fläche der Bedienleiste 2 einwirken, da hierdurch die Kraftsensoren 19 gegen die freien Endabschnitte 32 der Gelenkzapfen 21 gepresst werden. Die Kraftsensoren 19 können vorteilhafterweise auch Zugeinwirkungen erfassen, die durch ein Anheben der Bedienleiste 2 entstehen. Hierzu sind eine oder mehrere Federn vorgesehen, die in der Zeichnung beispielhaft als zwei Druckfedern 24 dargestellt sind, welche auf die Bedienleiste 2 einwirken und die Kraftsensoren 19 gegen die Stirnflächen der freien Endabschnitte 32 der Gelenkzapfen 21 pressen. Die Kraftsensoren 19 erfassen durch diese mechanische Vorspannung auch in der Ruheposition der Bedienleiste 2 eine Kraft, die sich bei einer Druckeinwirkung auf die Bedienleiste 2 vergrößert und bei einer Zugeinwirkung verringert. Somit können Verschwenkungen der Bedienleiste 2 sowohl nach unten wie nach oben durch den Kraftsensor 19 erkannt werden. Beim Überschreiten einer vorgegebenen positiven oder negativen Kraftänderungsschwelle wird durch eine hier nicht dargestellte Elektronik eine der Betätigung entsprechende Bedienfunktion ausgelöst. Die durch die Druckfedern 24 bewirkte Vorspannung verringert vorteilhafterweise zugleich das Lagerspiel der Bedienleiste 2.

Bei einer Betätigung der Bedienleiste 2 rückt der elektromagnetische Aktuator 11, angesteuert durch die erwähnte Elektronik, sein Ansteuerelement 25 gegen die Anschlagfläche 26 der Bedienleiste 2 aus. Das Ausrücken bewirkt aufgrund der Lagerung der Bedienleiste 2 auf den Schwenkgelenken 20 eine laterale Verschiebung der Bedienleiste 2, welche in der Figur 4 dargestellt ist. Erkennbar ist, dass die Gelenkzapfen 21 jeweils gegenüber ihrer in der Figur 3 abgebildeten Ausgangslage verschwenkt sind. Wird der Aktuator 11 stromlos, so führt die gegen die Anschlagfläche 26 wirkende Rückstellfeder 27 die Bedienleiste 2 in die Ausgangslage zurück. Diese kurze laterale Verschiebung über einen Weg von etwa einem Millimeter wird von einem Nutzer nicht als Verschiebung sondern als ein Nachgeben der Bedienleiste 2 wahrgenommen und ist somit zur Generierung einer Schalthaptik gut geeignet.

### Bezugszeichen

- 1: Vorrichtung
- 2: Bedienelement (Bedienleiste)
- 3: Sensorfläche(n)
- 4: Drehachse
- 4a, 4b: Endabschnitte (der Drehachse)
- 5: Gehäuse
- 6: Gehäuseoberteil
- 7: Gehäuseunterteil (Grundplatte)
- 8: mittlere Lagerstelle
- 9: seitliche Lagerstellen
- 10: Halterung
- 11: (elektromagnetischen) Aktuator
- 12: Schaltleiste
- 13: Gehäuseteil
- 14: Leiterplatte
- 15: Schaltflächen
- 16: Lichtquellen
- 17: Lichtleitkörper
- 18: Blendenkörper
- 19: Kraftsensor(en)
- 20: Schwenkgelenk(e)
- 21: Gelenkzapfen
- 22: Gelenklager
- 23: Aufnahme
- 24: Druckfeder(n) (Vorspannelement)
- 25: Ansteuerelement
- 26: Anschlagfläche
- 27: Rückstellfeder
- 28: Zentrierabschnitt
- 29: Langlochführungen
- 30: Zentrierabschnitt
- 31: (abgerundete) Endabschnitte
- 32: (freie) Endabschnitte

- x, y, z: Koordinatenachsen (Richtungen)
- y: Achsenrichtung
- z: Hochachse

## Patentansprüche

1. Vorrichtung (1) zur Bedienung mehrerer Funktionen in einem Kraftfahrzeug, mit einem Bedienelement (2), welches um eine Drehachse (4) verschwenkbar gelagert ist und dadurch zwischen wenigstens zwei Positionen beweglich ist, wobei zumindest einer der Positionen eine Schaltfunktion zugeordnet ist, wobei durch manuelle Betätigungen des Bedienelements (2) unterschiedliche Funktionen ausgelöst werden können,
wobei das Bedienelement (2) an einer Lagerstelle (8) bezüglich der Richtung der Hochachse (z) zentriert gelagert ist, und
wobei Endabschnitte (4a, 4b) der Drehachse (4) des Bedienelements (2) an zwei seitlichen Lagerstellen (9) in zwei entlang einer Hochachse (z) ausgerichteten Langlochführungen (29) gelagert sind,
**dadurch gekennzeichnet,**
**dass** das Bedienelement (2) beim Betätigen eine haptische Rückmeldung gibt, die durch einen elektromagnetischen Aktuator (11) erfolgt, welcher das Bedienelement (2) in der Achsenrichtung (y) der Drehachse (4) temporär verschiebt,
**dass** das Bedienelement (2) an einer mittleren Lagerstelle (8) zentriert gelagert ist, indem die mittlere Lagerstelle (8) an der die Ober- und Unterseite der Bedienleiste (2) durch entlang der Hochachse (z) ausgerichtete Zentrierabschnitte (28, 30) eingefasst ist, welche durch zwei Gehäuseteile (6, 7) gebildet werden, welche beidseitig des Bedienelements (2) angeordnet sind, und
**dass** sich das Bedienelement (2) auf den Gelenkzapfen (21) von mindestens zwei Schwenkgelenken (20) abstützt, und auf diesen schwimmend gelagert ist.

2. Vorrichtung nach Anspruch 1, **dadurch gekennzeichnet, dass** das Bedienelement (2) wenigstens zwei berührungssensitive kapazitive Sensorflächen (3) aufweist, und dass in Abhängigkeit davon, welche der Sensorflächen (3) berührt wird, unterschiedliche Funktionen ausgelöst werden.

3. Vorrichtung nach Anspruch 1, **dadurch gekennzeichnet, dass** das mindestens eine Schwenkgelenk (20) als ein Kugelgelenk ausgebildet ist.

4. Vorrichtung nach Anspruch 1, **dadurch gekennzeichnet, dass** mindestens ein Gelenkzapfen (21) sich auf einem Kraftsensor (19) abstützt.

5. Vorrichtung nach Anspruch 4, **dadurch gekennzeichnet, dass** der Kraftsensor (19) nach einem kapazitiven Wirkprinzip funktioniert.

6. Vorrichtung nach Anspruch 4, **dadurch gekennzeichnet, dass** der Kraftsensor (19) als scheibenförmig ausgebildet ist.

7. Vorrichtung nach Anspruch 4, **dadurch gekennzeichnet, dass** das Bedienelement (2) gegen den Kraftsensor (19) durch eine Kraft mindestens einer Feder (24) vorgespannt ist.

8. Vorrichtung nach Anspruch 2, **dadurch gekennzeichnet, dass** das Bedienelement (2) eine Schaltleiste (12) ausbildet, die mehrere kapazitive Sensorflächen (3) aufweist.

## Claims

1. A device (1) to operate several functions in a motor vehicle, with an actuating element (2) which is mounted on a rotary shaft (4) so that it can swivel and can be moved between at least two positions, with a switching function allocated to at least one of the positions, so that different functions can be initiated by manual actuations of the actuating element (2)
whereby the actuating element (2) is located centrally at a bearing point (8) in relation to the direction of the vertical axis (z) and
whereby the end-sections (4a, 4b) of the rotary shaft (4) to the actuating element (2) are mounted at two lateral bearing points (9) in two slots (29) directed along an vertical axis (z),
**characterized by the fact that**
when operated the actuating element (2) gives a tactile feedback via an electromagnetic actuator (11) which displaces the actuating element (2) temporarily in the axial direction (y) of the rotary shaft (4),
the actuating element (2) is held centrally at a middle bearing point (8), where the middle bearing point (8) is held at the upper and lower sides of the operating strip (2) by centering pegs (28, 30) made up of two housing sections (6, 7) which are aligned on both sides of the actuating element (2) along the vertical axis (z) and
the actuating element (2) is supported on the swivel studs (21) by at least two articulated links (20) and floats on these.

2. A device as in Claim 1, **characterized by** the fact that the actuating element (2) has at least two touch-sensitive capacitor surfaces (3) and that different functions are initiated, depending on which of the sensor surfaces (3) is touched.

3. A device as in Claim 1, **characterized by** the fact that at least one articulated link (20) is formed as a spherical link.

4. A device as in Claim 1, **characterized by** the fact that at least one articulated link (21) is supported on a force sensor (19).

5. A device as in Claim 4, **characterized by** the fact that the force sensor (19) functions on a capacitive operating principle.

6. A device as in Claim 4, **characterized by** the fact the force sensor (19) is formed as a disc-shaped sensor.

7. A device as in Claim 4, **characterized by** the fact that the actuating element (2) is pre-stressed against the force sensor (19) by the force of a spring (24), of which there is at least one.

8. A device as in Claim 2, **characterized by** the fact that the actuating element (2) forms a strip of switches (12) which has several capacitive sensor surfaces (3).

## Revendications

1. Dispositif (1) pour la commande de plusieurs fonctions dans un véhicule automobile, avec un élément de commande (2), lequel est monté en pivotement autour d'un axe de rotation (4) et peut être ainsi déplacé entre au moins deux positions, sachant qu'une fonction de commutation est associée à au moins l'une des positions, sachant que, par actionnement manuel de l'élément de commande (2), différentes fonctions peuvent être déclenchées,
sachant que l'élément de commande (2) est monté à un point de montage (8), en étant centré en référence à la direction de l'axe vertical (z),
sachant que les extrémités (4a, 4b) de l'axe de rotation (4) de l'élément de commande (2) sont montées sur deux points de montage latéraux (9) dans deux guidages en trous oblongs (29) orientés le long d'un axe vertical (z),
**caractérisé en ce que**,
l'élément de commande (2), lors de l'actionnement, donne une réponse haptique, qui est effectuée par un actionneur électromagnétique (11), lequel pousse temporairement l'élément de commande (2) dans la direction axiale (y) de l'axe de rotation (4),
que l'élément de commande (2) est monté, centré, à un point de montage central (8) du fait que le point de montage central (8) est serré sur la face supérieure et la face inférieure de l'élément de commande (2) par des sections de centrage (28,30), qui, orientées le long de l'axe vertical (z), sont formées par deux pièces de boitier (6, 7), lesquels sont disposées des deux côtés de l'élément de commande (2), et
que l'élément de commande (2) s'appuie sur le tourillon articulé (21) d'au moins deux articulations pivotantes (20) et est monté de manière flottante sur celles-ci.

2. Dispositif selon la revendication 1, caractérisé en ce l'élément de commande (2) présente au moins deux surfaces de captage (3) capacitives, tactiles et que différentes fonctions sont déclenchées selon laquelle des surfaces de captage (3) est effleurée.

3. Dispositif selon la revendication 1, **caractérisé en ce que** l'au moins une articulation pivotante (20) est réalisée sous la forme d'une articulation à rotule.

4. Dispositif selon la revendication 1, **caractérisé en ce qu'**au moins un tourillon articulé (21) prend appui sur un capteur de force (19).

5. Dispositif selon la revendication 4, **caractérisé en ce que** le capteur de force (19) fonctionne selon un principe actif capacitif.

6. Dispositif selon la revendication 4, **caractérisé en ce que** le capteur de force (19) est réalisé en forme de disque.

7. Dispositif selon la revendication 4, **caractérisé en ce que** l'élément de commande (2) est précontraint contre le capteur de force (19) par la force d'au moins un ressort (24).

8. Dispositif selon la revendication 2, **caractérisé en ce que** l'élément de commande (2) forme une baguette de commutation (12), laquelle présente plusieurs surfaces de captage capacitives (3).
